# FASCICULE DE BREVET EUROPEEN

(11) **EP 1 192 644 B1**
(45) Date de publication et mention de la délivrance du brevet: **16.04.2014**
(21) Numéro de dépôt: 00951659.2
(22) Date de dépôt: 12.07.2000
(51) Int. Cl.: H01L 21/67, H01L 21/683

(54) **PROCEDE DE COLLAGE ET DE DECOLLEMENT SUBSÉQUANT DE DEUX ELEMENTS**
VERFAHREN ZUM KLEBEN UND DARAUFFOLGENDEN TRENNEN VON ZWEI ELEMENTEN
METHOD FOR ADHEHRING TWO ELEMENTS AND SUBSEQUENTLY SEPARATING THEM

(30) Priorité: 12.07.1999 FR 9909007
(43) Date de publication de la demande: 03.04.2002
(73) Titulaire: Commissariat à l'Énergie Atomique et aux Énergies Alternatives, 75015 Paris (FR)
(72) Inventeur: Rayssac, Olivier, F-38000 Grenoble (FR); Moriceau, Hubert, F-38120 Saint Egrève (FR); Aspar, Bernard, F-38140 Rives (FR); Montmayeul, Philippe, F-38190 Bernin (FR)
(74) Mandataire: Weber, Etienne Nicolas
(86) Numéro de dépôt international: PCT/FR2000/002014
(87) Numéro de publication internationale: WO 2001/004933

(56) Documents cités:
- EP-A- 0 925 888
- US-A- 3 918 150
- US-A- 5 029 418
- PATENT ABSTRACTS OF JAPAN vol. 012, no. 091 (M-679), 24 mars 1988 (1988-03-24) -& JP 62 230537 A (CANON INC), 9 octobre 1987 (1987-10-09)

## Description

### Domaine technique

La présente invention concerne un procédé de décollement de deux éléments adhérant l'un à l'autre selon des faces d'adhérence, le décollement pouvant être obtenu sous l'action d'un fluide et/ou d'un élément mécanique permettant d'amorcer localement le décollement. Elle concerne aussi un dispositif pour la mise en oeuvre de ce procédé.

L'invention s'applique en particulier au domaine de la micro-électronique afin de décoller deux plaquettes adhérant l'une à l'autre. Elle est d'un intérêt tout particulier dans la manipulation de plaques minces, fragiles et très flexibles.

### Etat de la technique antérieure

Le document FR-A-2 752 332 divulgue un procédé de séparation d'une plaquette de support par insertion, à l'interface de collage d'un élément séparateur assez flexible pour ne pas rayer les surfaces. Cet élément séparateur est composé de plusieurs parties permettant une visée minimale, lors de l'opération d'ouverture de l'interface, pour être compatible avec un objectif industriel. Ce procédé a été développé dans le cadre de plaques collées par l'intermédiaire de forces d'attraction.

L'article intitulé "Bonding of silicon wafers for silicon-on-insulator" de W.P. MASZARA et al. paru dans la revue J. Appl. Phys. 64 (10), 15 novembre 1988, pages 4943-4950, concerne la mesure d'énergie de collage par la méthode de la lame insérée à l'interface de deux éléments adhérant l'un à l'autre. Pour une même énergie de collage, plus la lame est épaisse, plus l'onde d'ouverture se propage loin par rapport au point d'ouverture à l'interface de collage. De même, plus l'énergie de collage est forte, moins l'onde de décollement se propage pour une même épaisseur de lame.

Pour appliquer un procédé de séparation tel que décrit dans le document FR-A-2 752 332, il est avantageux que l'énergie de surface soit faible et que l'élément séparateur soit épais. Ainsi, une onde de décollement peut se propager sur une longueur significative par rapport au diamètre de plaques à séparer.

Cependant, l'usage d'un élément séparateur épais peut conduire à une fracture de l'une des plaques du fait d'un rayon de courbure trop faible. De plus, il a été démontré que plus l'énergie de collage est importante, plus il faut insérer doucement la lame ou l'élément séparateur au niveau de l'interface pour éviter le risque de fracture des plaques, la relaxation des contraintes d'ouverture étant rendue possible par une ouverture suffisamment lente.

Par ailleurs, dans le cas d'une structure comportant plusieurs interfaces, l'ouverture peut se propager d'une interface vers une autre, associée, par exemple, à une énergie de collage plus faible.

Il est connu également que l'énergie de collage entre deux éléments augmente lorsqu'un traitement thermique est appliqué. On peut se référer à ce sujet à l'article de C. MALEVILLE et al., paru dans la revue Electrochemical Society Proceedings Volume 97-36, pages 46-55. A titre d'exemple, des plaques de silicium dont les surfaces ont été rendues hydrophiles sont collées l'une à l'autre. Une énergie de collage supérieure à 1 J/m² est obtenue pour des collages suivis d'un traitement thermique à 1000°C. Ainsi, pour des plaques de silicium de 525 µm d'épaisseur (épaisseur typique de plaques de 100 mm de diamètre), une lame de 600 µm d'épaisseur parvient à provoquer une ouverture de l'interface de collage sur une longueur de l'ordre de 3 cm ou moins. Cette longueur d'ouverture est insuffisante pour assurer la séparation des plaques. Il est alors nécessaire d'introduire un séparateur plus épais pour propager cette ouverture. Cela entraîne une diminution de la flexibilité des éléments séparateurs et comporte les risques cités précédemment.

L'insertion d'une lame n'est pas la seule méthode permettant de désolidariser deux éléments collés l'un à l'autre pour constituer une structure. Le document WO 98/52 216 décrit un procédé de clivage contrôlé d'un substrat par introduction de particules, provenant par exemple d'une source de vapeur d'eau, à partir d'une face de la structure où l'interface aboutit. Cependant, cette technique ne peut être utilisée que pour cliver des empilements dans lesquels une zone a été au préalable fragilisée, par exemple par implantation ionique. L'interface de décollement ne peut alors correspondre qu'à la zone fragilisée. Le brevet américain N° 5 863 375 divulgue le décollement de deux plaques collées l'une à l'autre pour constituer une structure. Le décollement est obtenu sous l'effet d'un jet de liquide dirigé selon le plan de l'interface vers une face de la structure où aboutit l'interface.

D'autre part, les faces des plaques à décoller peuvent avoir reçu, avant leur collage, un ou plusieurs dépôts de films minces. Dans ce cas, il n'est pas possible d'utiliser l'enseignement du brevet US 5 863 375. En effet, le jet de liquide de décollement agit aussi sur les films déposés. Comme il n'y a pas de localisation précise de l'interface de collage, le décollement peut se produire au niveau de l'une des couches déposées si l'énergie d'adhérence d'un film sur sa plaque est inférieure à l'énergie d'adhérence de l'interface de collage entre les deux plaques. Cette technique est de plus très coûteuse au niveau de la consommation du fluide utilisé, une grande quantité de ce fluide n'agissant pas sur l'interface de collage.

Ces techniques connues de décollement au moyen d'un jet de particules ou d'un jet de liquide remplaçant une lame séparatrice révèlent d'autres problèmes. Un premier problème tient à la localisation précise de l'interface d'ouverture. D'autres problèmes sont liés au fait que pour appliquer aisément les techniques d'ouverture il faut que l'interface de collage ne soit pas trop résistante en tenant compte des divers traitements thermiques qui peuvent être pratiqués.

De façon classique, on peut contrôler l'énergie de collage par une préparation des surfaces tendant à modifier leur caractère hydrophile ou leur rugosité. A ce sujet, on peut se reporter, par exemple, au document "influence of surface characteristics on direct wafer bonding" de O. Rayssac et coll., 2ème conférence internationale des matériaux pour la microélectronique 14/15 septembre 1998, ION Communications Ltd.

Le document EP-A-0 703 609 divulgue un procédé de transfert d'une couche mince semi-conductrice d'un substrat support sur un substrat cible en utilisant le fait que l'énergie de collage entre la couche et le substrat support est inférieure à l'énergie de collage entre la couche et le substrat cible. Lorsqu'une force d'arrachement et/ou de cisaillement et/ou torsion est appliquée à la structure, le décollement se fait entre la couche et le substrat support, entraînant ainsi le transfert de la couche.

Ce procédé doit, comme précédemment, tenir compte du problème éventuel de résistance de l'interface de collage. De plus, la couche mince est collée sur le substrat support afin de subir un certain nombre de traitements dont, par exemple, un ou plusieurs dépôts de films minces dont l'énergie d'adhérence peut se révéler plus faible que l'énergie de collage des substrats entre eux. En particulier, des méthodes de séparation basées sur une traction ou un cisaillement ou une torsion, appliquées globalement aux substrats ne peuvent pas être utilisées.

Le document EP-A-0 925 888 décrit un procédé de décollement de deux tranches semi-conducteur. Un jet de fluide à haute pression est dirigé sur une couche poreuse dans une des deux tranches pour provoquer le décollement.

Le JP-A-62 230 537 décrit un procédé de décollement d'un masque adhéré à une tranche de semi-conducteur par une dépression ou un vide.

Le document US-A-3 918 150 décrit un procédé de décollement des puces adhérées à une couche sur une membrane extensible.

US-A-5 029 418 décrit un procédé de décollement de deux éléments d'une structure comprenant les deux éléments mis en contact adhérent l'un à l'autre par des faces d'adhérence respectives et présentant au moins une interface. Une cavité débouchant au niveau de l'interface est réalisée dans au moins un des éléments, de façon à permettre le passage dans la cavité d'une pression de fluide. Le contact adhérent est un contact adhérent maintenu par une dépression ou un vide.

### Exposé de l'invention

L'invention a été conçue pour remédier aux inconvénients rapportés ci-dessus.

A cet effet, l'invention concerne plus précisément un procédé de collage de deux éléments, puis de décollement ou amorçage de décollement de ces deux éléments conformément à la revendication 1.

Les moyens de séparation peuvent comprendre, entre autres, des moyens exerçant une action mécanique et/ou une pression de fluide et/ou exerçant une action chimique sur au moins l'une des faces d'adhérence au niveau de l'interface.

Ainsi, la force appliquée à l'interface doit être comprise comme résultant d'une action mécanique et/ou d'une pression de fluide et/ou d'une action chimique.

Les cavités peuvent être réalisées à la périphérie ou dans une région plus centrale des éléments. En particulier elles peuvent être réparties sur tout ou partie d'une interface d'adhérence entre les éléments, de façon à contrôler la propagation de l'ouverture de décollement. Les cavités peuvent également s'étendre jusqu'à une interface distincte de celle formée par les faces d'adhérence des éléments, à l'intérieur de l'un des éléments.

Si plusieurs interfaces sont prévues pour les moyens de séparation, les cavités peuvent être agencées de façon à amorcer le décollement à un endroit déterminé des interfaces.

Lorsque les moyens de séparation comprennent des moyens exerçant une pression de fluide dans la zone d'interface et que ce fluide est liquide, ces moyens de séparation peuvent comprendre une excitation par micro-ondes ou impulsionnelle du fluide liquide.

Les deux éléments peuvent être mis en adhérence l'un à l'autre avec une énergie d'adhérence variable en fonction des différentes régions de l'interface d'adhérence de manière à amorcer le décollement à un endroit déterminé de l'interface.

De plus, les moyens de séparation peuvent être tels que le décollement des deux éléments auniveau d'une interface se produise en un ou plusieurs endroits de façon simultanée ou séquentielle.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1A représente, en coupe transversale, une première possibilité de réalisation d'un dispositif destiné au décollement de deux éléments adhérant l'un à l'autre,
- les figures 1B et 1C sont des coupes schématiques partielles illustrant des variantes possibles pour la réalisation du dispositif de la figure 1A.
- la figure 2 représente, vu en coupe transversale, une deuxième possibilité de réalisation d'un dispositif destiné au décollement de deux éléments adhérant l'un à l'autre,
- les figures 3A à 3C illustrent le déroulement du procédé selon l'invention,
- les figures 4A à 4D illustrent l'application du procédé selon l'invention à l'obtention d'une membrane semi-conductrice dont les faces principales reçoivent des traitements selon les techniques de la micro-électronique,
- les figures 5A à 5F illustrent le transfert d'une puce électronique d'un premier substrat vers un substrat de réception en utilisant le procédé selon la présente invention,
- les figures 6 à 12 illustrent schématiquement différentes possibilités de conformation d'une face d'adhérence d'un élément d'une structure, destinée à un décollement conforme à l'invention,
- la figure 13 est une coupe transversale d'une structure forme de deux éléments et présentant deux zones d'interface pour un décollement non conforme à l'invention,
- la figure 14 est une vue de dessus d'une face d'adhérence d'un élément d'une structure particulière destinée à un décollement,
- la figure 15 est une coupe schématique d'une structure incluant l'élément de la figure 14.

### Description détaillée de modes de réalisation de l'invention

L'invention permet le décollement de deux éléments dont les surfaces d'adhérence adhérent par le collage à l'aide d'une colle (polymères, époxy...) ou le collage par adhérence moléculaire. L'invention s'applique particulièrement bien au cas où ces éléments sont des plaquettes et notamment au cas où l'une des plaquettes est une plaquette semi-conductrice dont les deux faces principales peuvent recevoir un traitement selon les techniques de la micro-électronique.

L'idée consiste à amener un moyen, notamment un fluide et/ou un outil mécanique, au niveau de l'interface de collage de façon à engendrer une action permettant de décoller tout ou partie des éléments en offrant le choix de pouvoir localiser la zone d'interface à décoller en premier lieu. L'introduction, par exemple, d'un fluide peut se faire, au niveau de l'interface, à l'aide d'une gravure réalisée préalablement au collage dans l'un des éléments ou dans les deux. Des essais ont démontré qu'une telle gravure peut être effectuée sans gêner le collage. Pour permettre l'introduction d'un fluide, cette gravure doit communiquer avec l'extérieur. Elle peut être communicante en périphérie ou au travers de l'un des éléments. Ainsi, le décollement peut être amorcé au voisinage de la zone gravée.

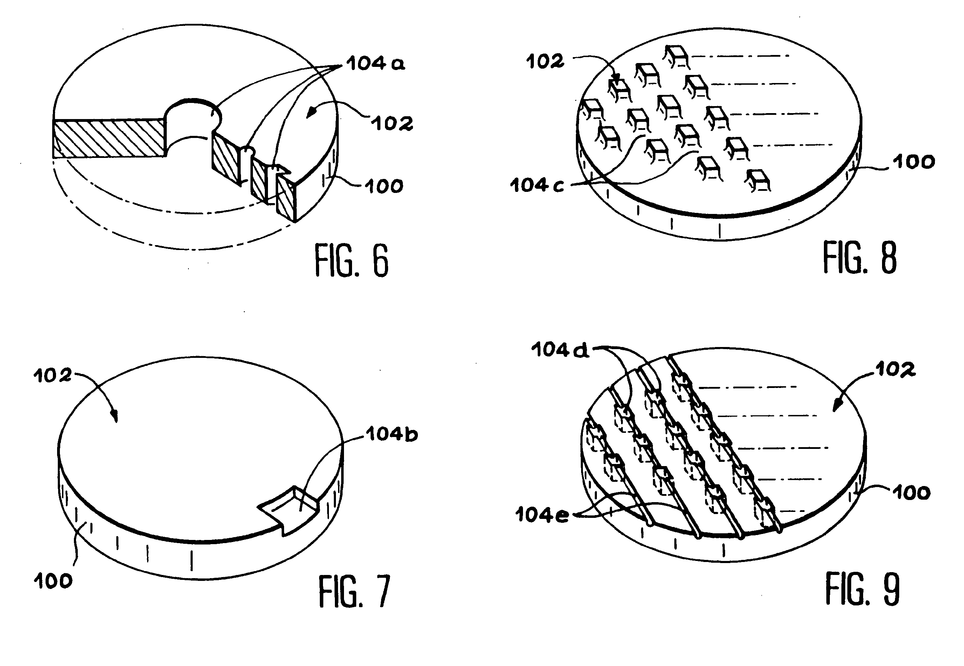

La gravure peut être réalisée pour constituer, par exemple, un réseau de plots, un réseau de cavités traversantes ou non ou avoir une forme en colimaçon ou en anneaux ou encore en secteurs. Ces différentes possibilités sont illustrées par les figures 6 à 12 décrites plus loin.

L'introduction du fluide peut se faire à l'aide d'un adaptateur au niveau de la cavité réalisée par gravure ou bien en plaçant la structure formée des deux éléments collés dans une enceinte remplie du fluide dont la pression est contrôlée.

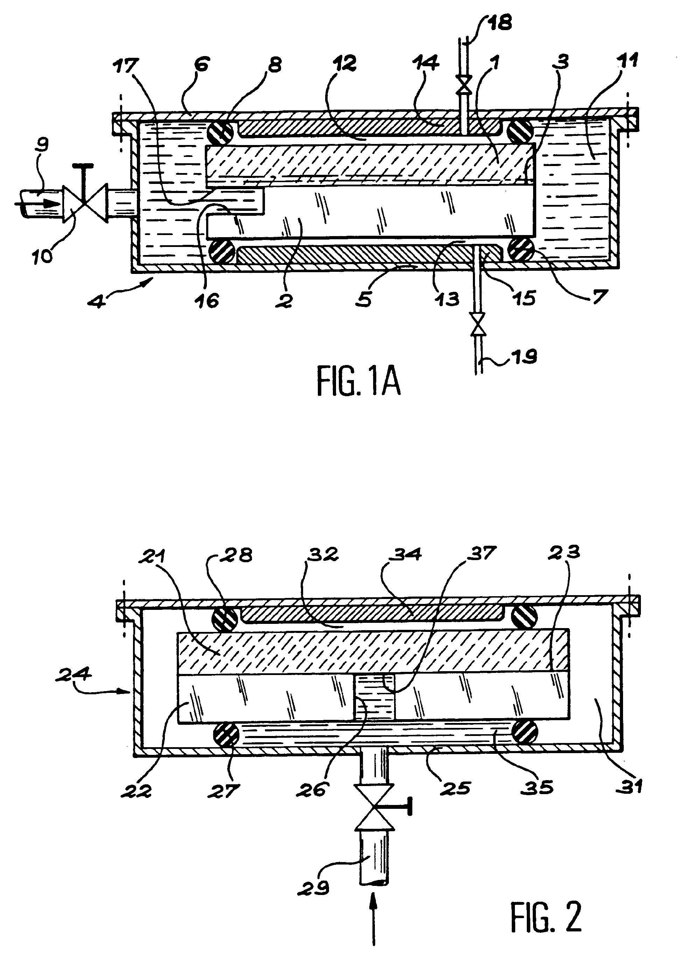

La figure 1A montre en coupe une première possibilité de réalisation d'un dispositif permettant le décollement de deux éléments. Dans l'exemple de la figure, les éléments sont deux plaquettes circulaires 1 et 2 collées l'une à l'autre selon une interface 3. Le dispositif comporte une enceinte étanche 4 de forme cylindrique et comportant une paroi inférieure 5 et une paroi supérieure 6. Des joints, par exemple toriques, 7 et 8 sont fixés respectivement sur les parois inférieure 5 et supérieure 6 et viennent en appui sur les faces principales des plaquettes. Le dispositif est dimensionné en fonction de la taille des plaquettes 1 et 2 à décoller. Le dispositif est raccordé latéralement à une conduite 9 d'amenée de fluide sur laquelle est montée une vanne 10.

Lorsque la structure composée des plaquettes 1 et 2 collées entre elles est installée dans le dispositif, l'enceinte 4 est partagée en plusieurs chambres : une chambre 11 dite chambre de haute pression, destinée à recevoir le fluide amené par la conduite 9, et deux chambres 12 et 13 situées respectivement au-dessus et au-dessous de la structure à décoller et appelées chambres de basse pression.

La pression que doit exercer le fluide pour engendrer le décollement dépend de l'énergie d'adhérence entre les plaquettes. Dans le cas d'une adhérence moléculaire, celle-ci est fixée en particulier par la préparation des surfaces avant collage ainsi que par le ou les traitements thermiques subis par la structure. Pour rester dans la limite de déformation élastique et ne pas déformer irrémédiablement les plaquettes, il est possible d'adapter la distance entre la structure collée et la surface intérieure de l'enceinte située en vis-à-vis des plaquettes. Des butées 14 et 15 fixées sur la surface intérieure de l'enceinte permettent de limiter les déformations induites dans les plaquettes et peuvent favoriser le décollement. La distance initiale entre butée et plaquette correspondante dépend notamment de l'épaisseur de la plaquette et de sa nature.

La figure 1A montre que la plaquette 2 comporte une gravure périphérique 16 permettant au fluide de parvenir sur une zone d'interface 17.

Les références 18, 19 désignent des conduites respectivement en communication avec les chambres de basse pression 12, 13 qui peuvent être prévues pour contrôler la pression d'un fluide se trouvant dans ces chambres. Les conduites 18, 19 peuvent être de simples évents, susceptibles d'être mis en communication, par exemple avec la pression atmosphérique. Elles peuvent aussi être reliées à des moyens pour ajuster la pression d'un fluide, par exemple un gaz situé dans les chambres de basse pression, de façon à contrôler avec précision le décollement. La pression du fluide dans les chambres de basse pression est cependant maintenue à une valeur plus faible que la pression du fluide appliqué à la chambre de haute pression, pour autoriser le décollement.

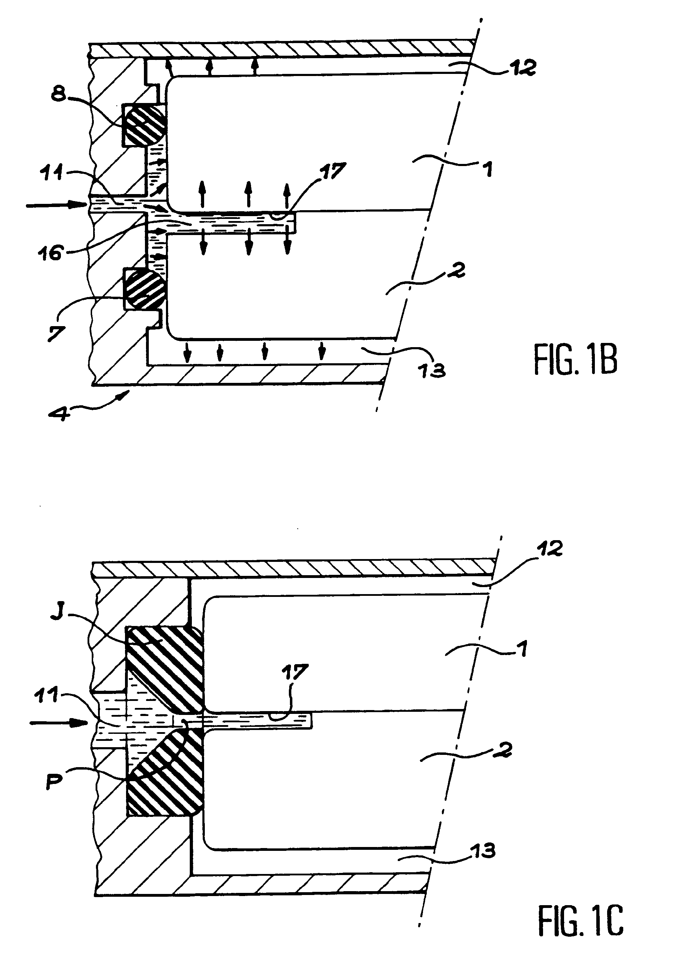

La figure 1B montre, de façon partielle et à plus grande échelle, une autre possibilité de réalisation du dispositif de décollement constituant une variante par rapport à la figure 1A. Les parties identiques, similaires ou correspondantes à celle de la figure 1 sont repérées avec les mêmes références numériques et leur exposé n'est pas repris ici.

On observe sur la figure 1B que les joints, par exemple toriques, 7 et 8 ne sont plus fixés sur les parois supérieure et inférieure du dispositif mais sur les parois latérales qui sont en regard des tranches des plaquettes.

Les joints 7 et 8 viennent respectivement en appui sur les tranches des plaquettes à une distance suffisante de l'interface de collage pour ne pas entraver l'accès du fluide sous pression vers la gravure périphérique 16 et donc à la zone d'interface 17.

L'action du fluide sur les faces d'adhérence dans la zone d'interface est indiquée par des flèches. Des flèches indiquent également le décollement des plaquettes repoussées vers les chambres 12, 13 de basse pression.

La figure 1C montre, également de façon partielle et à plus grande échelle, encore une autre possibilité de réalisation du dispositif de décollement, constituant une variante par rapport aux figures 1A et 1B. Les parties identiques ou similaires à celles des figures précédentes sont toujours indiquées avec les mêmes références.

On observe sur la figure 1C que les joints toriques ont été éliminés et remplacés par un joint à lèvres J. Le joint J assure l'étanchéité entre la paroi latérale du dispositif et les première et deuxième plaquettes. Il assure donc également l'étanchéité entre la chambre de haute pression 11 et les chambres de basse pression 12, 13.

Un passage P pratiqué dans le joint J permet au fluide sous pression d'accéder à la zone d'interface 17 des plaquettes 1, 2.

La figure 2 montre encore une autre possibilité de réalisation d'un dispositif permettant le décollement de deux plaquettes circulaires 21 et 22 collées l'une à l'autre selon une interface 23. Une conduite 29 d'amenée de fluide est connectée différemment de celle de la figure 1A. Elle débouche au centre de la paroi inférieure 25 de l'enceinte 24. Cette disposition partage l'enceinte 24 en une chambre de haute pression 35 et en deux chambres de basse pression : la chambre 31 et la chambre 32 et dans laquelle peut se déformer la plaquette 21.

La figure 2 montre que la plaquette 22 possède un trou central traversant 26 permettant au fluide de parvenir sur une zone d'interface 37. Le trou central peut être remplacé et/ou complété par d'autres trous traversant la plaquette (avec des diamètres identiques ou différents).

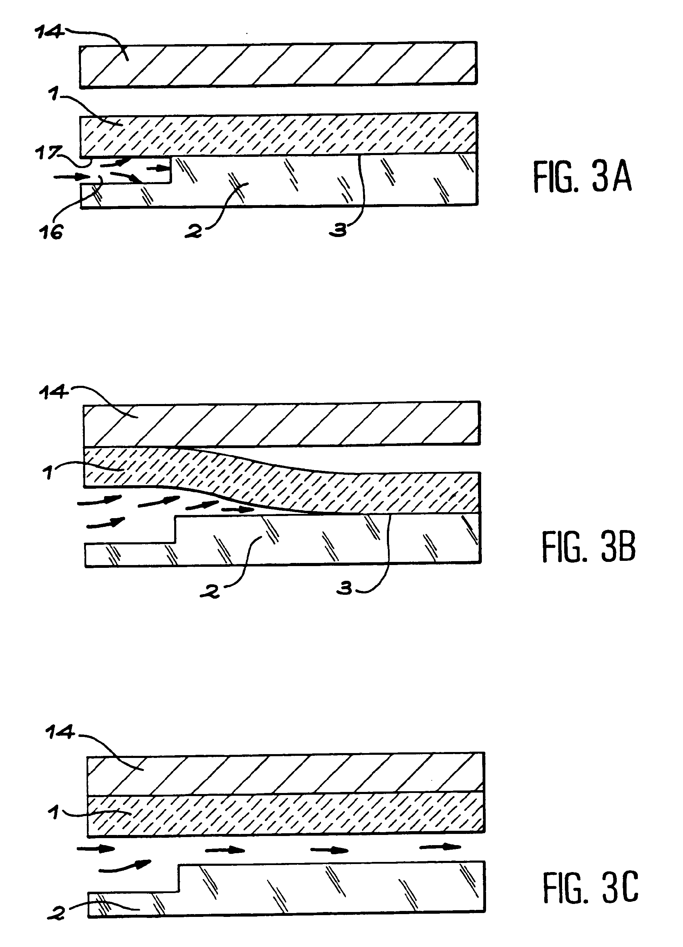

Les figures 3A à 3C illustrent un exemple du déroulement du procédé de décollement des plaquettes 1 et 2 de la figure 1. Au début de l'opération, le fluide est introduit et commence à exercer son action sur les parois de la cavité 16 et de la zone d'interface 17 comme le montrent les flèches sur la figure 3A. La figure 3B montre un exemple d'amorce du décollement entre les plaquettes 1 et 2 sous l'action de la pression de fluide et le rôle des butées 14, 15. La plaquette 1 dans cet exemple se déforme plus que la plaquette 2. Cet exemple se produit dans le cas d'une plaquette plus fine que l'autre. Ainsi, dans le cas d'applications en électronique de puissance, on peut, grâce à l'invention, réaliser et manipuler des membranes de quelques dizaines de micromètres. La figure 3C montre les plaquettes 1 et 2 totalement séparées.

Dans les cas représentés sur les figures 1 et 2, les plaquettes 1 et 21 sont par exemple des éléments ou membranes où des circuits peuvent être élaborés tandis que les plaquettes 2 et 22 sont des éléments réservés à l'opération de décollement. Les plaquettes 2 et 22 peuvent être désignées sous l'appellation de poignées de transfert. Ces poignées sont facilement réutilisables.

L'intérêt de situer la gravure dans la plaquette servant de poignée est que, en plus de localiser le décollement de la structure dans le plan horizontal, ceci permet de localiser l'interface dans le plan vertical de la structure. En effet, comme indiqué plus haut dans l'état de la technique antérieure, si des couches ont été déposées avant le collage des plaquettes (voir les couches figurées en traits mixtes sur la figure 1) et si ces couches ont une adhérence plus faible que l'interface de collage, seule cette localisation verticale permettra le décollement au niveau de l'interface de collage.

Pour accroître l'efficacité du fluide, il peut être intéressant, qu'en plus de l'action de pression, ce fluide puisse exercer une action chimique au niveau de l'interface, facilitant ainsi le décollement. Pour une interface à base d'oxyde de silicium, on peut utiliser une solution formée de HF dilué dans de l'eau pour contrôler la vitesse de gravure. Si une face à décoller doit être préservée (face traitée par les techniques de la micro-électronique par exemple), la partie à préserver peut être protégée par une couche d'arrêt (par exemple du silicium polycristallin) sur lequel l'oxyde d'interface est déposé ou formé.

En outre, dans le cas d'un fluide liquide, le décollement peut être facilité, par exemple, par l'usage d'une excitation de type micro-ondes, impulsionnelle, etc...

Il peut être avantageux de préparer l'une des faces d'adhérence d'au moins l'une des plaquettes, en partie ou dans sa totalité, pour que l'énergie de collage qui en résulte présente des variations dans le plan de l'interface de collage. On peut, par exemple, définir une zone centrale de l'interface où l'adhérence sera plus forte qu'en périphérie. Cette différence d'énergie sera mise à profit pour induire le décollement ultérieur en localisant l'amorce du décollement en périphérie de la structure. De façon plus générale, cette technique peut être avantageusement utilisée pour générer des zones localisées où l'énergie de collage est différente de l'énergie de collage des autres zones.

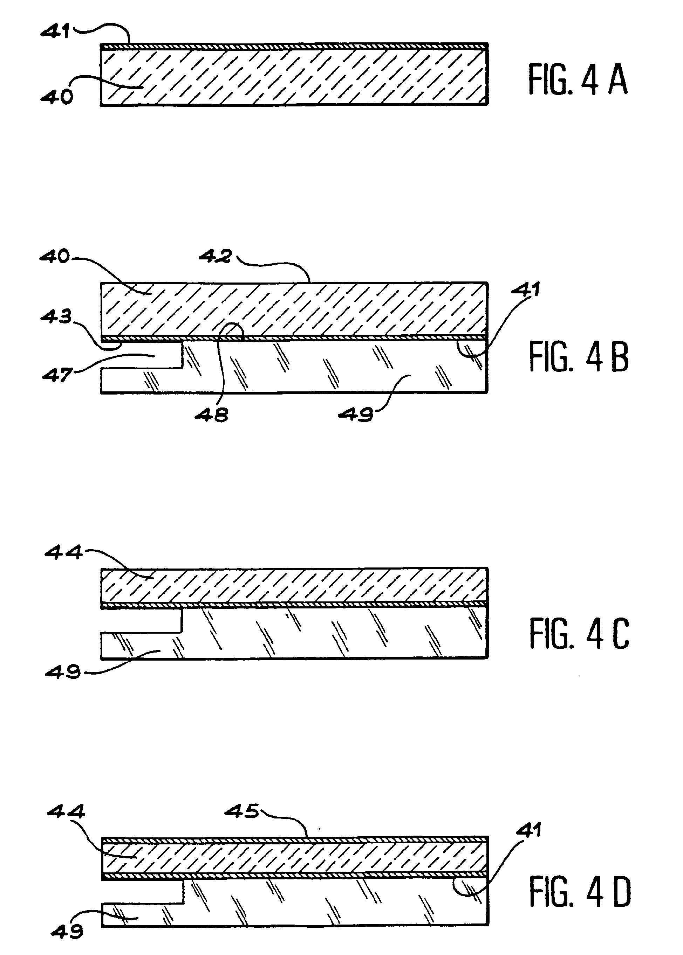

Les figures 4A à 4D illustrent l'obtention d'une membrane, par exemple en matériau semi-conducteur, dont les faces principales sont traitées selon les techniques de la micro-électronique. L'objectif est d'obtenir une membrane d'environ, par exemple, 100 µm d'épaisseur, traitée sur ses deux faces à partir d'une plaquette de silicium standard de 4 pouces et de 525 µm d'épaisseur. Cette plaquette va devoir subir différentes opérations, par exemple des recuits thermiques (typiquement à 1100°C), des traitements mécaniques (polissage, rectification), des traitements chimiques (gravure sèche ou humide), des dépôts (oxydes ou métaux), des implantations.

Ces différentes opérations impliquent des manipulations de la membrane, ce qui est problématique lorsque son épaisseur est de l'ordre de 100 µm ou moins. L'invention permet de remédier à ce problème.

La figure 4A montre une plaquette de silicium 40 destinée à fournir une membrane. La plaquette est représentée avec l'une de ses faces principales, la face 41, qui a déjà subi des traitements selon les techniques de la micro-électronique et qui a reçu, par exemple, une couche d'oxyde d'encapsulation. La couche d'oxyde est éventuellement polie pour présenter une surface plane.

La figure 4B montre la plaquette 40 (en position retournée par rapport à la figure 4A) mise en contact par sa face 41 avec la face 48 d'une plaquette 49. La plaquette 49 est avantageusement une plaquette de silicium oxydé. On peut ainsi obtenir un collage par adhérence moléculaire hydrophile SiO₂/ SiO₂. L'énergie du collage peut être contrôlée en agissant sur le caractère plus ou moins hydrophile ou plus ou moins rugueux des surfaces. Il est alors possible de réaliser des opérations selon les techniques de la micro-électronique à partir de l'autre face principale, la face 42, de la plaquette 40 en toute sécurité d'un point de vue mécanique pour obtenir finalement une membrane traitée sur ses deux faces.

Comme indiqué ci-dessus, pour obtenir l'adhérence moléculaire désirée, on peut jouer sur le caractère hydrophile et/ou sur la rugosité selon des techniques classiques. En combinant les deux méthodes, on peut obtenir, après recuit à 1100°C, une énergie de collage de l'ordre de 500 mJ/m² pour une structure SiO₂/SiO₂ dont les rugosités de surface sont typiquement de 0,6 nm RMS (valeur quadratique moyenne). Cette valeur est largement inférieure à celle (2 J/m²) obtenue pour un collage de plaquettes dont la rugosité de surface est de l'ordre de 0,2 nm. Avec cette valeur d'énergie de collage, le procédé de l'invention permet de décoller la plaquette 40 de la plaquette 49 et d'obtenir finalement une fine membrane ayant subi au moins un traitement sur au moins l'une de ses faces avec un risque minimal de détérioration.

A titre d'exemple encore, cette technique peut être avantageusement utilisée pour générer des zones localisées dont l'énergie de collage est différente de l'énergie de collage du reste de la structure. La variation d'énergie de collage, en différentes zones, pourra être obtenue par une technique utilisant un masquage partiel d'au moins une des surfaces en contact dans le collage. Par exemple, il est possible de générer des rugosités de surface différentes dans les zones masquées et non masquées par une attaque chimique, une gravure sèche, une implantation ionique....

Avantageusement, la rugosité peut être contrôlée de façon à induire l'énergie de collage la plus faible dans la (les) zone(s) choisie(s) pour l'amorce du décollement.

La plaquette 49 (voir la figure 4B) présente une partie gravée 47 formant un exemple de cavité de type encoche, ce qui donne accès à une zone d'interface 43 sur laquelle peut s'exercer une pression de fluide.

La figure 4C montre la structure obtenue successivement par rectification et éventuellement polissage de la plaquette 40 afin de transformer cette plaquette en membrane 44.

La face libre 45 de la membrane 44 peut alors être traitée par les techniques de la micro-électronique. On obtient une membrane traitée sur ses deux faces (voir la figure 4D), qui sera décollée de la plaquette 49 conformément à l'invention.

Dans les traitements envisageables on peut faire des dépôts de couches, des gravures, voire même reporter une autre structure sur la membrane notamment pour la rigidifier.

Pour certaines applications, par exemple, en opto-électronique, il apparaît intéressant de pouvoir associer une puce ou un composant opto-électronique réalisé par exemple sur un matériau III-V avec un circuit électronique par exemple réalisé sur du silicium. Dans ce cas, pour réaliser un tel objet, une voie consiste à venir reporter la puce en matériau III-V sur une plaquette entière contenant les circuits. Le report sur une plaquette entière permet la réalisation d'étapes technologiques postérieures au report. A titre d'exemple, on peut citer, parmi les opérations postérieures au report, celles permettant de réaliser les contacts entre par exemple la puce et le circuit. L'invention permet le transfert de puces électroniques sur des plaquettes entières. Elle offre l'avantage de permettre l'amincissement des puces.

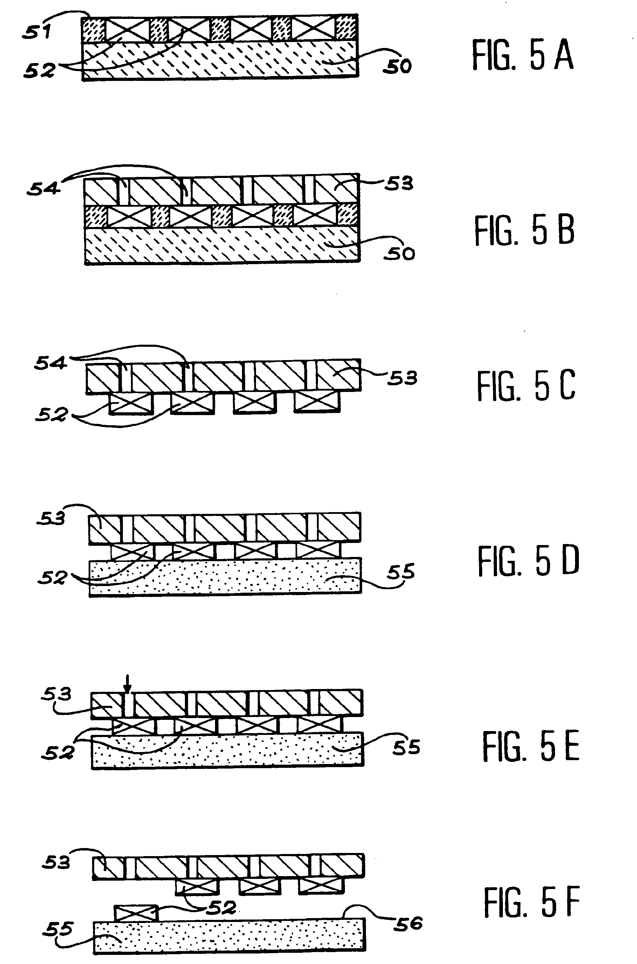

Les figures 5A à 5F illustrent le transfert d'une puce électronique d'un premier substrat vers un substrat de réception.

La figure 5A montre une plaquette 50 dont l'une des faces principales, la face 51, a été traitée pour réaliser des puces 52 individualisées. Les puces peuvent être, par exemple, des composants électroniques ou opto-électroniques. Le matériau de la plaquette 50 peut être du type III-V ou du GaAs. La surface des puces peut être de l'ordre de 250 µm × 250 µm.

La figure 5B montre la solidarisation de la plaquette 50, côté puces, avec une plaquette poignée 53. La solidarisation peut être réalisée par une mise en contact des deux plaquettes avec un collage par adhérence moléculaire ou à l'aide d'une couche intermédiaire de colle ou de résine. La solidarisation est réalisée avec une énergie de collage contrôlée. Par exemple, dans le cas d'un collage moléculaire, cette énergie peut être choisie par le contrôle de la rugosité de surface et/ou de l'hydrophilie et/ou du pourcentage de la surface en contact.

Dans le cas où l'on veut transférer des puces, la plaquette poignée 53 est réalisée de telle sorte que des trous 54 la traversent pour autoriser la communication entre les deux faces principales de la poignée 53 collée aux puces. La taille et le pas des trous sont adaptés à la taille et au pas des puces. Dans cet exemple, le pas des puces est de l'ordre de 250 µm. Le diamètre des trous doit être adapté au pas et à la technique de décollement. Dans le cas de l'utilisation d'un outil, par exemple, du genre pointeau, il exerce une action mécanique. Dans le cas de l'utilisation d'un fluide de décollement, la dimension des trous peut être très faible, inférieure ou égale à la dimension des puces. Dans le cas où les puces sont plus grandes, par exemple 500 µm × 500 µm, la dimension du trou peut être par exemple de 200 µm. L'utilisation d'un pointeau est alors facilitée. Suivant la dimension de l'élément à transférer, un ou plusieurs pointeaux peuvent être utilisés. L'extrémité du pointeau peut être pointue, plate ou conique. Le pointeau peut être par ailleurs percé en son extrémité, par exemple pour amener le fluide. Une combinaison du fluide et de l'outil peut être avantageusement envisagée.

La figure 5C représente la structure obtenue après amincissement de la plaquette 50 jusqu'à l'épaisseur désirée et séparation des puces 52 entre elles. Si des composants opto-électroniques sont réalisés sur une couche de GaAs, ils peuvent avoir une épaisseur de l'ordre de 10 µm. La séparation des puces entre elles peut être réalisée par gravure ou plus simplement à l'aide d'une scie de découpe.

La structure amincie est mise en contact avec une plaquette de réception 55 (voir la figure 5D).

Comme indiqué par une flèche sur la figure 5E, une puce 52 par exemple peut être décollée de la plaquette poignée 53 par l'intermédiaire d'un outil et/ou d'un fluide de transfert.

L'emplacement de la puce 52 à transférer ayant été préparé sur la face 56 de la plaquette de réception 55, l'écartement des plaquettes 53 et 55 laisse la puce décollée de la plaquette 53 sur la plaquette 55 tandis que les autres puces restent sur la plaquette 53.

Ce procédé trouve également un intérêt pour le transfert de circuits minces pour les applications cartes à puces ou "tickets jetables".

La présente invention présente de nombreux avantages. Tout d'abord, elle peut permettre de travailler sur les deux faces d'une plaquette, par exemple de silicium, sans risque de détérioration. Il est ainsi possible de traiter une première face d'une plaquette en protégeant la deuxième face, par adhérence à un support. Ensuite, la face traitée peut être elle même protégée par adhérence à un autre support pendant que l'autre face, après décollement, est traitée à son tour. Cette invention peut aussi faciliter l'utilisation de plaques fines, également appelée membranes (inférieures à 300 µm d'épaisseur pour un diamètre de 100 mm). On rencontre, par exemple, de plus en plus ce type de plaques dans des applications de micro-électronique, comme par exemple en électronique de puissance. L'avantage de ce genre de plaques est de pouvoir y réaliser des structures en limitant, du fait de leur faible épaisseur, les problèmes d'échauffement thermiques ou de courant de fuite lors de l'utilisation. En contrepartie, ces plaques sont le lieu de fortes contraintes, lors de l'utilisation, à cause des traitements thermiques qu'elles subissent et de leur faible épaisseur. Il est, par exemple, très risqué de passer ce genre de plaques dans des fours car elles ont tendance à se déformer et même dans les cas extrêmes à se casser du fait de la température de procédé et des contraintes générées par les traitements thermiques. De plus, ces plaques ne sont pas toujours compatibles avec les équipements utilisés en micro-électronique, car ceux-ci sont souvent étalonnés pour recevoir des plaques d'épaisseur standard (par exemple 525µm pour des plaques de silicium d'un diamètre de 100 mm). Enfin, le transport et la manipulation de ce type de plaquettes très minces doivent être limités car les risques de cassure sont bien plus grands que pour des plaquettes standard. Pour remédier à ces problèmes, l'adhérence d'une plaquette fine à une plaquette support permet la rigidification de la plaquette fine pour lui conférer les propriétés mécaniques d'une plaquette épaisse pendant les différentes étapes de traitement. La dissociation des plaquettes peut intervenir en cours ou en fin de procédé.

Toutes les méthodes décrites ci-dessus peuvent s'appliquer aussi bien pour le décollement d'éléments de grandes dimensions (par exemple des plaquettes entières de plusieurs centimètres de diamètre) que pour le décollement d'éléments de petites dimensions (par exemple de plusieurs dizaines de micromètres de large).

Les figures 6 à 12 décrites ci-après représentent de façon très schématique différents exemples de possibilités de réalisation des éléments d'une structure, conçus pour un décollement conforme à l'invention. Ces éléments sont par exemple des poignées telles que décrites précédemment. Sur toutes ces figures, des références identiques désignent des parties identiques ou similaires.

Il convient de préciser que les exemples illustrés par les figures 6 à 12 ne sont pas exhaustifs et que les différentes possibilités de réalisation de cavités que montrent ces figures peuvent être combinées entre elles.

La référence 100 désigne de façon générale le corps de l'élément ou poignée qui, dans les exemples illustrés, se représente comme une plaquette circulaire. On définit également une face 102 de l'élément qui correspond à la face d'adhérence, destinée à être mise en contact adhérent avec un autre élément conjugué pour former une structure. C'est aussi selon le plan de la face d'adhérence 102 que les deux éléments de la structure doivent être séparés ultérieurement.

La figure 6 montre un premier exemple où des cavités 104a se présentent comme des trous traversant de part en part l'élément 100 pour relier la face d'adhérence à une face opposée. Les trous peuvent présenter différents diamètres et différentes formes. Ils définissent sur la face d'adhérence une zone d'interface permettant un décollement localisé préférentiel. On observe par ailleurs que les trous sont pratiqués dans une région plus ou moins centrale de l'élément.

L'utilisation d'un élément 200 conforme à la figure 6 a été illustrée précédemment en référence à la figure 2.

La figure 7 montre un élément 100 présentant une unique cavité 104b, non traversante, sous la forme d'une encoche pratiquée à la périphérie de l'élément. La cavité 104b correspond à l'encoche 16 de la plaquette 2 représentée sur les figures 1A à 1C.

La figure 8 montre un élément 100 avec une face d'adhérence dans laquelle de larges canaux 104c sont gravés de façon à entourer et délimiter des îlots 108. Les canaux 104c permettent l'application d'un fluide sous pression, mais constituent également des cavités au sens de l'invention.

La figure 9 montre un élément 100 avec une face d'adhérence 102 dans laquelle une pluralité de cavités 104d non traversantes sont pratiquées pour former un réseau de cavités. Les cavités sont reliées entre elles par des canaux 104e qui débouchent à la périphérie de l'élément 100. Les canaux 104e constituent également des moyens d'accès à la zone d'interface comportant les cavités 104d.

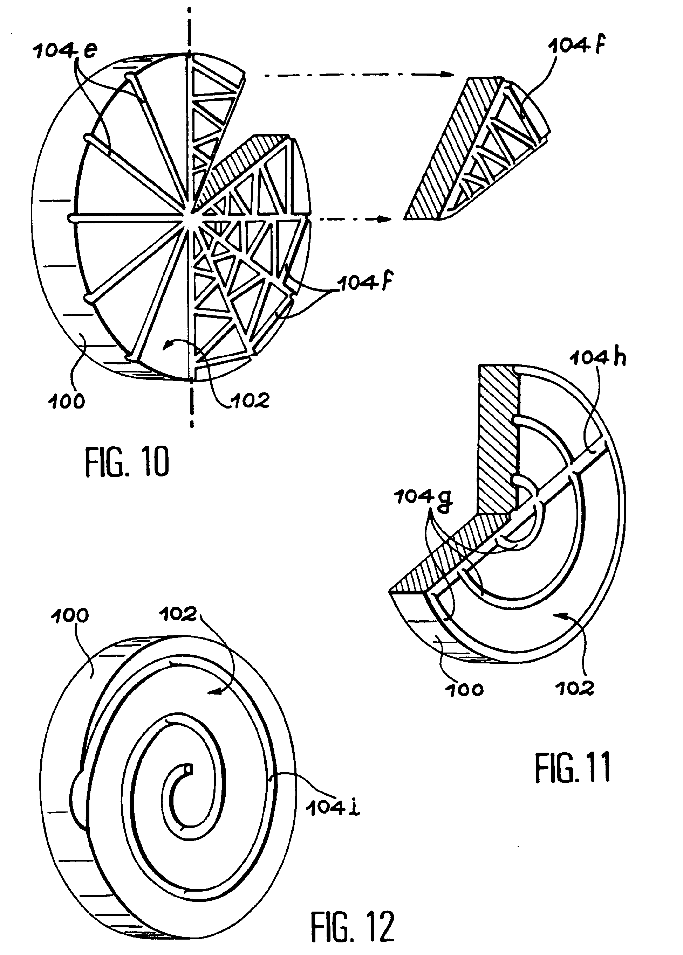

La figure 10 montre un élément 100 dont la face d'adhérence 102 est divisée en secteurs par des canaux 104e s'étendant selon des rayons. Les secteurs peuvent eux-mêmes être parcourus par des canaux 104f selon un motif d'entretoisement.

Selon une variante, représentée à la figure 11, des canaux peuvent aussi se présenter comme des canaux circulaires concentriques 104g, communiquant par un canal radial 104h.

Selon encore une autre possibilité, représentée à la figure 12, un canal circulaire en colimaçon 104i peut s'étendre depuis le centre jusqu'à la périphérie de la face d'adhérence 102.

Les canaux 104e, 104f, 104g, 104h et 104i des figures 10 à 12 permettent l'accès d'un fluide et/ou d'un outil de décollement mais constituent également des cavités au sens de l'invention. Ils définissent donc des zones d'interface permettant un décollement localisé privilégié.

La zone d'interface est déterminée de façon générale par l'emplacement et/ou la répartition des canaux sur la face d'adhérence de l'élément.

Cette répartition permet également de contrôler précisément l'adhérence de l'élément avec un élément conjugué et leur décollement ultérieur. Une zone avec une forte densité de canaux permet en effet un décollement plus aisé qu'une zone avec une plus faible densité de canaux.

A titre d'exemple, pour un canal en colimaçon, tel que représenté à la figure 12, la facilité de décollement dépend de l'écartement entre les spires. Le décollement aura donc tendance à s'amorcer au centre de l'élément et se propager de façon sensiblement concentrique vers la périphérie.

Ceci est le cas également avec les exemples des figures 10 et 11.

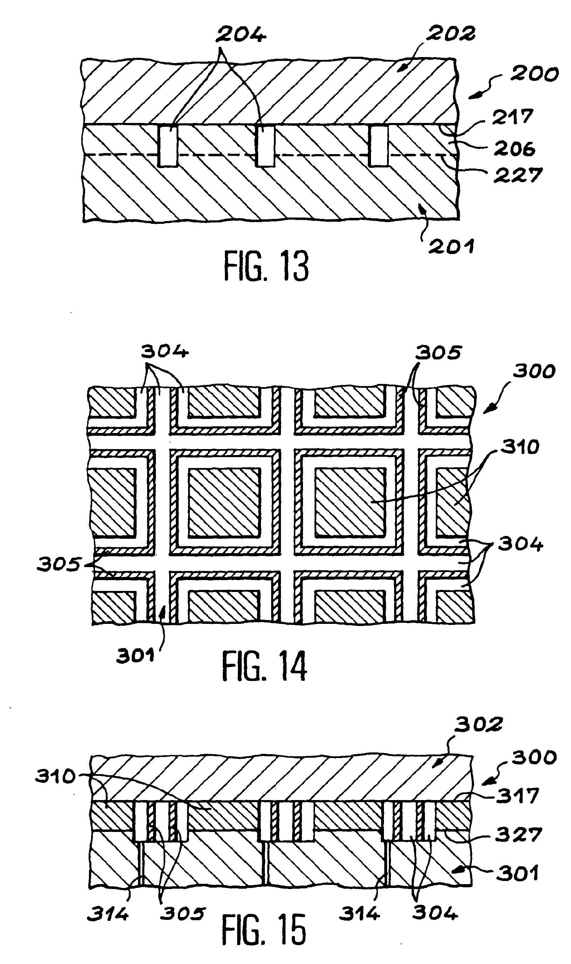

La figure 13 montre une structure 200 formée d'un premier élément 201 et d'un deuxième élément 202.

Les deux éléments sont rendus solidaires par leurs faces d'adhérence qui définissent ainsi une première interface 217.

Le premier élément 201 a subi une implantation ionique pour y former, à faible profondeur, une zone fragilisée qui forme une deuxième interface 227.

La zone fragilisée s'étend de façon sensiblement parallèle à la surface du premier élément, c'est-à-dire de façon sensiblement parallèle à sa face d'adhérence, de façon à y délimiter une couche mince superficielle 206.

Des cavités débouchantes 204 sont gravées dans le premier élément et s'étendent à travers la couche mince superficielle 206 pour déboucher au niveau de la deuxième interface 227.

Dans l'exemple de la figure 13, la force de liaison s'exerçant entre le premier et le deuxième éléments, c'est-à-dire entre leurs faces d'adhérence, est supérieure à la force de liaison de la deuxième interface 227. La force de liaison de la deuxième interface est comprise ici comme la force devant être vaincue pour provoquer le décollement selon la zone fragilisée.

Lorsqu'un fluide est appliqué à travers les cavités 204, la structure de la figure 13 subira un décollement, et plus précisément une séparation selon la deuxième interface.

La figure 14 montre une face d'adhérence d'un élément 301 d'une structure 300. Celle-ci est prévue pour le transfert sélectif de différentes parties 310 de cet élément 300.

Les parties repérées avec la référence 310 sont entourées de cavités 304 qui sont cloisonnées par des parois 305 du premier élément.

Les cavités permettent de délimiter latéralement les différentes parties 310 et s'étendent jusque sur une interface enterrée, sous la forme d'une zone fragilisée telle que décrite précédemment.

La figure 15 montre en coupe l'élément 301, solidaire d'un deuxième élément 302 sur lequel les parties 310 doivent être reportées.

On peut observer que des accès de fluide 314 permettent d'alimenter sélectivement les cavités 304 du premier élément, qui entourent certaines parties 310. Ceci permet de provoquer leur séparation selon la deuxième interface 327 pour leur transfert sélectif sur le deuxième élément 302

A cet effet, il convient de préciser que seulement certaines parties 310 peuvent être rendues solidaires du deuxième élément 302 au niveau de la première interface 317.

Dans ce cas encore, les forces d'adhérence au niveau de la première interface 317 sont supérieures à celles au niveau de la deuxième interface 327, c'est-à-dire supérieures aux forces qu'il faut vaincre pour détacher les parties 310 de l'élément 301.

## Revendications

1. Procédé de collage de deux éléments (1, 2), puis de décollement ou amorçage de décollement de ces deux éléments, chaque élément comprenant une face d'adhérence,
le procédé comprenant :
- la gravure de l'un au moins des éléments pour réaliser au moins une cavité débouchant au niveau de la face d'adhérence, de façon à permettre le passage dans la cavité de moyens de séparation,
- le collage des deux éléments au niveau de leurs faces d'adhérence, par collage à l'aide d'une colle ou par collage moléculaire, pour former au moins une interface de collage, et
- l'application, de façon localisée au travers de la cavité, desdits moyens de séparation, au niveau de l'interface de collage, pour amorcer le décollement des deux éléments à partir de l'interface de collage et pour le poursuivre, éventuellement, jusqu'à la séparation complète des deux éléments.

2. Procédé selon la revendication 1, dans lequel les moyens de séparation comprennent des moyens exerçant une action mécanique au niveau de l'interface.

3. Procédé selon l'une quelconque des revendications 1 et 2, dans lequel les moyens de séparation comprennent des moyens exerçant une pression de fluide au niveau de l'interface.

4. Procédé selon l'une quelconque des revendications 1 à 3, dans lequel les moyens de séparation comprennent des moyens exerçant une action chimique sur au moins l'un des éléments au niveau de l'interface.

5. Procédé selon l'une quelconque des revendications 1 à 4, dans lequel la ou les cavités (16) sont réalisées à la périphérie d'au moins un élément.

6. Procédé selon l'une quelconque des revendications 1 à 4, dans lequel la ou les cavités (26) sont réalisées dans une région intérieure d'au moins un élément.

7. Procédé selon l'une quelconque des revendications 1 à 6, dans lequel au moins une cavité traverse au moins un élément de part en part.

8. Procédé selon la revendication 1, dans lequel, plusieurs cavités étant prévues, ces cavités sont agencées de façon à amorcer le décollement à des endroits déterminés de l'interface.

9. Procédé selon la revendication 2, dans lequel, le fluide étant un fluide liquide, les moyens de séparation comprennent une excitation par micro-ondes du fluide liquide.

10. Procédé selon la revendication 1, dans lequel les deux éléments adhèrent l'un à l'autre avec une énergie d'adhérence différente dans différentes régions d'une interface de collage entre les éléments, de manière à amorcer le décollement à un endroit déterminé de l'interface de collage.

## Patentansprüche

1. Verfahren zum Verkleben von zwei Elementen (1, 2) und zum anschließenden Lösen oder Einleiten des Lösens dieser beiden Elemente voneinander, wobei jedes Element eine Haftfläche aufweist,
wobei das Verfahren die folgenden Schritte umfasst:
das Ätzen mindestens eines der Elemente zur Herstellung mindestens eines Hohlraums, welcher sich an der Haftfläche öffnet, so dass eine Trennvorrichtung in den Hohlraum gelangen kann;
das Verkleben der beiden Elemente an deren Haftflächen durch Verkleben mit Hilfe eines Klebstoffs oder durch Molekularkleben, um mindestens eine Klebeschnittstelle zu bilden; und
das Anwenden der Trennvorrichtungen in einer lokalisierten Weise quer durch den Hohlraum an der Klebeschnittstelle, um das Lösen der beiden Elemente voneinander von der Klebeschnittstelle aus anzuregen bzw. einzuleiten, und um das Lösen gegebenenfalls bis zur vollständigen Trennung der beiden Elemente fortzusetzen.

2. Verfahren nach Anspruch 1, in welchem die Trennvorrichtungen Mittel aufweisen, welche eine mechanische Wirkung an der Schnittstelle entwickeln.

3. Verfahren nach einem der Ansprüche 1 und 2, in welchem die Trennvorrichtungen Mittel aufweisen, welche einen Fluiddruck an der Schnittstelle entwickeln.

4. Verfahren nach einem der Ansprüche 1 bis 3, in welchem die Trennvorrichtungen Mittel aufweisen, welche eine chemische Wirkung auf mindestens eines der Elemente an der Schnittstelle ausüben.

5. Verfahren nach einem der Ansprüche 1 bis 4, in welchem der oder die Hohlräume (16) am Rand mindestens eines Elements realisiert sind.

6. Verfahren nach einem der Ansprüche 1 bis 4, in welchem der oder die Hohlräume (26) in einem Innenbereich mindestens eines Elements realisiert sind.

7. Verfahren nach einem der Ansprüche 1 bis 6, in welchem zumindest ein Hohlraum mindestens ein Element von einer Seite zur anderen Seite durchquert.

8. Verfahren nach Anspruch 1, in welchem mehrere Hohlräume vorgesehen sind, wobei diese Hohlräume derart angeordnet sind, dass sie das Lösen an festgelegten Stellen der Schnittstelle einleiten.

9. Verfahren nach Anspruch 2, in welchem es sich bei dem Fluid um ein flüssiges Fluid handelt, wobei die Trennvorrichtungen eine Mikrowellenerregung des flüssigen Fluids einschließen.

10. Verfahren nach Anspruch 1, in welchem die beiden Elemente mit einer unterschiedlichen Adhäsionsenergie in unterschiedlichen Bereichen einer Klebeschnittstelle zwischen den Elementen aneinander haften, so dass die Lösung an einer festgelegten Stelle der Klebeschnittstelle eingeleitet wird.

## Claims

1. A process for bonding two elements (1, 2), then separating or initiating the separation of these two elements, each element comprising an adherence face,
the process comprising :
engraving at least one of the elements for carrying out at least one cavity emerging at the adherence face, so as to enable passage of separation means in the cavity;
-bonding the two elements at their adherence faces by bonding by means of a glue or by molecular adherence so as to form at least one bonding interface, and
-applying the said separation means in a localized manner through the cavity, at the bonding interface to initiate the separation of the two elements from the bonding interface and to continue the separation process, if applicable, until complete separation of the two elements.

2. A process according to claim 1, wherein the separation means comprise means exerting a mechanical action at the interface.

3. A process according to any of claims 1 and 2, wherein the separation means comprise means exerting a fluid pressure at the interface.

4. A process according to any of claims 1 to 3, wherein the separation means comprise means exerting a chemical action on at least one of the elements at the interface.

5. A process according to any of claims 1 to 4, in which the cavity or cavities (16) are made at the periphery of a least one element.

6. A process according to any of claims 1 to 4, wherein the cavity or cavities (26) are made in an inner region of at least one element.

7. A process according to any of claims 1 to 6, wherein at least one cavity penetrates through at least one element from side to side.

8. A process according to claim 1, wherein several cavities are provided, these cavities are arranged so as to initiate the separation at determined locations of the interface.

9. A process according to claim 2, wherein the fluid being a liquid fluid, the separation means comprise a microwave excitation of the liquid fluid.

10. A process according to claim 1, wherein the two elements adhere to one another with a different adherence energy in different regions of a bonding interface between the elements, so as to initiate separation at a determined location of the bonding interface.
